# EUROPÄISCHE PATENTANMELDUNG

(11) **EP 3 367 768 A1**
(43) Veröffentlichungstag der Anmeldung: **29.08.2018**
(21) Anmeldenummer: 17158432.9
(22) Anmeldetag: 28.02.2017
(51) Int. Cl.: H05K 7/20

(54) **ONLINE-USV-ANLAGE MIT KOMBINIERTER LUFT- UND WASSERKÜHLUNG**

(71) Anmelder: Piller Group GmbH, 37520 Osterode am Harz (DE)
(72) Erfinder: Huntgeburth, Joachim, 37115 Duderstadt (DE); Benke, Thomas, 99734 Nordhausen (DE); Ueffing, Norbert, verstorben (DE)
(74) Vertreter: REHBERG HÜPPE + PARTNER

(57) **Zusammenfassung**

Bei einer USV-Anlage (1) sind folgende Bestandteile in einem Maschinenschrank (16) angeordnet: ein ausgangsseitig an einen Gleichspannungszwischenkreis (9) angeschlossener AC/DC-Wandler (7), ein eingangsseitig an den Gleichspannungszwischenkreis (9) angeschlossener DC/AC-Wandler (8) mit Leistungsendstufen (33) und Filterinduktivitäten (34), ein elektrisch an den Gleichspannungszwischenkreis (9) angeschlossener Motor/Generator (10), an dessen Rotor eine Schwungmasse mechanisch angekoppelt ist, ein Bypass (11) zu der Reihenschaltung des AC/DC-Wandlers (7) mit dem DC/AC-Wandler (8), in dem ein Bypassschalter (12) angeordnet ist, eine Steuerung (14) für den AC/DC-Wandler (7), den DC/AC-Wandler (8), den Motor/Generator (10) und den Bypassschalter (12) sowie ein Luft aus einer Umgebung (25) des Maschinenschranks (16) durch Luftfilter (26) in den Maschinenschrank (16) einsaugendes, die Luft in dem Maschinenschrank (16) durch einen Wärmetauscher (27) blasendes und die Luft wieder aus dem Maschinenschrank (16) ausstoßendes Gebläse (24). Der Wärmetauscher (27) ist zusammen mit einer Kühlmittelpumpe (37), Kühlmittelkanälen (46) durch den Motor/Generator (10) und Kühlkörpern (38) für die Leistungsendstufen (33) in einem Kühlmittelkreislauf (35) angeordnet.

## Beschreibung

### TECHNISCHES GEBIET DER ERFINDUNG

Die Erfindung bezieht sich auf eine USV-Anlage, bei der folgende Bestandteile in einem Maschinenschrank angeordnet sind: (i) ein ausgangsseitig an einen Gleichspannungszwischenkreis angeschlossener AC/DC-Wandler mit einer Leistungsendstufe, (ii) ein eingangsseitig an den Gleichspannungszwischenkreis angeschlossener DC/AC-Wandler mit einer weiteren Leistungsendstufe, (iii) ein an den Gleichspannungszwischenkreis angeschlossener bidirektionaler DC/AC-Wandler mit noch einer weiteren Leistungsendstufe, (iv) ein AC-seitig an den bidirektionalen DC/AC-Wandler angeschlossener Motor/Generator, an dessen Rotor eine Schwungmasse mechanisch angekoppelt ist, (v) ein Bypass zu der Reihenschaltung des AC/DC-Wandlers mit dem DC/AC-Wandler, in dem ein Bypassschalter angeordnet ist, (vi) eine Steuerung für den AC/DC-Wandler, den DC/AC-Wandler, den Motor/Generator und den Bypassschalter sowie (vii) ein Luft aus einer Umgebung des Maschinenschranks durch Luftfilter in den Maschinenschrank einsaugendes, die Luft in dem Maschinenschrank durch einen Wärmetauscher blasendes und die Luft wieder aus dem Maschinenschrank ausstoßendes Gebläse.

Aufgrund der Reihenschaltung des AC/DC-Wandlers mit dem DC/AC-Wandler ist diese USV-Anlage eine sogenannte Online-USV, die an den Ausgang des DC/AC-Wandlers angeschlossene Lasten über diese Reihenschaltung aus einer Hauptwechselstromquelle versorgen kann. Dabei kann mit Hilfe der Reihenschaltung des AC/DC-Wandlers mit dem DC/AC-Wandler die Qualität des der Last zur Verfügung gestellten Wechselstroms gegenüber der Hauptwechselstromquelle verbessert werden. Wenn jedoch bereits die Ausgangsqualität des Wechselstroms ausreichend ist, kann die Last unter Umgehung des AC/DC-Wandlers und des DC/AC-Wandlers über den Bypass direkt aus der Hauptwechselstromquelle versorgt werden. Bei teilweisem oder auch vollständigem Ausfall der Hauptwechselstromquelle kann die Last über den Motor/Generator, den bidirektionaler DC/AC-Wandler und den DC/AC-Wandler aus der Schwungmasse versorgt werden. Dazu ist die Schwungmasse zuvor über den AC/DC-Wandler, den bidirektionaler DC/AC-Wandler und den Motor/Generator in Rotation zu versetzen, um kinetische Energie in ihr zu speichern.

Insbesondere handelt es sich bei der USV-Anlage um eine kompakte, in einem Maschinenschrank angeordnete USV-Anlage mit bezogen auf Ihre Abmessungen hoher Leistungsdichte. Bei einer derart hohen Leistungsdichte bedarf der Wärmehaushalt der USV-Anlage besonderer Beachtung.

### STAND DER TECHNIK

Aus der EP 1 226 643 B1 ist eine USV-Anlage mit einem Gehäuse, einer Schwungrad-Energiespeicher-Einheit, die eine Kurzzeit-Reserveenergie für einen Verbraucher bereitstellt und in dem Gehäuse angeordnet ist, und einer USV-Elektronikeinheit bekannt, die dem Verbraucher kontinuierlich Leistung von einer der folgenden Leistungsquellen zuführt: der Schwungradeinheit, einer Netzspannungsversorgung und einer Langzeit-Notstromquelle, die ebenfalls in dem Gehäuse angeordnet ist. Ein Kühlsystem zum Kühlen der Schwungradeinheit und der USV-Elektronikeinheit weist ein Zwangsluft-Konvektionskühlsystem auf, das Kühlluft über die Schwungradeinheit und die USV-Elektronikeinheit leitet. Konkret leitet das Konvektionskühlsystem die Kühlluft zunächst über die Schwungradeinheit und dann über die USV-Elektronikeinheit. Weiterhin weist das Konvektionskühlsystem mehrere Gebläse und jedes Gebläse ein Dämpfungselement auf, das durch das Gebläse angesaugte Luft wieder aus dem Gehäuse herausleitet. Die Dämpfungselemente weisen jeweils eine Klappe auf, die in Abhängigkeit von der Druckdifferenz zwischen dem Innen- und dem Außendruck des Gehäuses geöffnet und geschlossen wird. Das Gehäuse umfasst eine stabile Basis, an der die Schwungradeinheit gelagert ist, und einen an der Basis montierten Rahmen, der eine Steuerungselektronik für die Schwungradeinheit und die USV-Elektronikeinheit hält. Die Basis und der Rahmen des Gehäuses sind gemeinsam durch Seitenpaneele und Zugangstürpaneele sowie einen Deckel, in dem die Klappen vorgesehen sind, verkleidet.

Aus der DE 198 52 125 C1 ist eine Vorrichtung zur unterbrechungsfreien Stromversorgung bekannt, die zwischen eine Wechselstromquelle, deren Unterbrechungen zu überbrücken sind, und einen oder mehrere mit Wechselstrom zu versorgende Verbraucher zu schalten ist. Die Vorrichtung umfasst mindestens einen Gleichrichter für den ankommenden Wechselstrom, Akkumulatoren für das Zwischenspeichern elektrischer Energie, mindestens einen Wechselrichter für die Batteriespannung der Akkumulatoren und eine Steuerelektronik. Elektrische Wickelkörper, insbesondere Spulen und Drosseln, und elektronische Halbleiterbausteine der Vorrichtung werden von einem Leistungsstrom durchflossen. Die Wickelkörper sind in einem mit einer ersten Kühlflüssigkeit befüllten Becken angeordnet. Ein Leitungssystem für eine zweite Kühlflüssigkeit weist dem ersten Kühlmittel und den Halbleiterbausteinen zugewandte Wärmeaustauschflächen auf. Für die erste Kühlflüssigkeit ist ein Druckausgleichsmittel vorgesehen, das ein komprimierbares Gasvolumen aufweist. Für die zweite Kühlflüssigkeit ist ein Wärmetauscher vorgesehen, um dieser Wärme zu entziehen. Bei der bekannten Vorrichtung zur unterbrechungsfreien Stromversorgung wird, um den Aufbau von Verschmutzungen zu vermeiden, keine Kühlluft von außen durch die Vorrichtung hindurchgeführt. Sie weist ein geschlossenes Gehäuse für alle elektronischen und elektrischen Bestandteile auf, aus dem bzw. in das nur Stromleitungen und Leitungen für die zweite Kühlflüssigkeit heraus- bzw. hereinführen. Der Wärmetauscher ist außerhalb dieses Gehäuses angeordnet.

### AUFGABE DER ERFINDUNG

Der Erfindung liegt die Aufgabe zugrunde, eine USV-Anlage der eingangs beschriebenen Art, die dem Oberbegriff des unabhängigen Patentanspruchs 1 entspricht, hinsichtlich ihres Kühlsystems so zu verbessern, dass ihre Leistungsdichte erhöht werden kann, ohne dass Probleme mit ihrem Wärmehaushalt auftreten.

### LÖSUNG

Die Aufgabe der Erfindung wird durch eine USV-Anlage mit den Merkmalen des unabhängigen Patentanspruchs 1 gelöst. Bevorzugte Ausführungsformen der erfindungsgemäßen USV-Anlage sind in den abhängigen Patentansprüchen definiert.

### BESCHREIBUNG DER ERFINDUNG

Bei einer erfindungsgemäßen USV-Anlage sind die folgenden Bestandteile in einem Maschinenschrank angeordnet: (i) ein ausgangsseitig an einen Gleichspannungszwischenkreis angeschlossener AC/DC-Wandler mit einer Leistungsendstufe, (ii) ein eingangsseitig an den Gleichspannungszwischenkreis angeschlossener DC/AC-Wandler mit einer weiteren Leistungsendstufe, (iii) ein an den Gleichspannungszwischenkreis angeschlossener bidirektionaler DC/AC-Wandler mit noch einer weiteren Leistungsendstufe, (iv) ein AC-seitig an den bidirektionalen DC/AC-Wandler angeschlossener Motor/Generator, an dessen Rotor eine Schwungmasse mechanisch angekoppelt ist, (v) ein Bypass zu der Reihenschaltung des AC/DC-Wandlers mit dem DC/AC-Wandler, in dem ein Bypassschalter angeordnet ist, (vi) eine Steuerung für den AC/DC-Wandler, den DC/AC-Wandler, den Motor/Generator und den Bypassschalter sowie (vii) ein Luft aus einer Umgebung des Maschinenschranks durch Luftfilter in den Maschinenschrank einsaugendes, die Luft in dem Maschinenschrank durch einen Wärmetauscher blasendes und die Luft wieder aus dem Maschinenschrank ausstoßendes Gebläse. Dabei ist der Wärmetauscher erfindungsgemäß zusammen mit einer Kühlmittelpumpe, Kühlmittelkanälen durch den Motor/Generator und Kühlkörpern für die Leistungsendstufen in einem geschlossenen Kühlmittelkreislauf angeordnet.

Die erfindungsgemäße USV-Anlage weist ein hybrides Kühlsystem auf, das die Wärmekapazität von Luft aus der Umgebung sowohl für eine Grundkühlung der in dem Maschinenschrank angeordneten Bestandteile als auch für eine verstärkte Wärmeabfuhr von kritischen Bestandteilen mit Hilfe eines Kühlmittels nutzt. Das Kühlmittel wird in dem Wärmetauscher abgekühlt, durch den die in den Maschinenschrank eingesaugte Luft in den Maschinenschrank geblasen wird, bevor sie wieder aus dem Maschinenschrank ausgestoßen wird. Das Kühlmittel wird von einer Kühlmittelpumpe durch einen Kühlmittelkreislauf zirkuliert, in dem neben dem Wärmetauscher Kühlmittelkanäle durch den Motor/Generator und Kühlkörper für die Leistungsendstufen angeordnet sind. Zumindest werden also der Motor/Generator und die Leistungsendstufen der Wandler mit Hilfe des Kühlmittels gekühlt. Dies schließt jedoch nicht aus, dass auch noch für weitere Bestandteile der USV-Anlage innerhalb des Maschinenschranks eine Kühlmittelkühlung vorgesehen wird. Beispielsweise die Steuerung der USV-Anlage wird aber regelmäßig ausreichend mit Luft gekühlt, da die hierdurch fließenden elektrischen Leistungen nur klein sind. Weiter ist zu berücksichtigen, dass in der Steuerung keine größeren Spannungen auftreten, die bei Verunreinigungen innerhalb des Maschinenschranks mit einer relevanten Gefahr von Durchschlägen verbunden wären. Dort wo größere Spannungen in der erfindungsgemäßen USV-Anlage auftreten, wie beispielsweise bei den Leistungsendstufen der Wandler, kommt die Kühlmittelkühlung zum Einsatz. Zudem wird durch die Luftfilter, durch die hindurch die Luft in den Maschinenschrank eingesaugt wird, einer Verunreinigung des Inneren des Maschinenschranks vorgebeugt.

Ungewöhnlich ist bei der erfindungsgemäßen USV-Anlage die Einbindung des Motor/Generators in den Kühlmittelkreislauf. Dies erlaubt jedoch eine ganz erhebliche Steigerung der Leistungsdichte der USV-Anlage in Bezug auf die kinetischen Energie, die in der mechanisch an den Rotor des Motor/Generators angekoppelten Schwungmasse gespeichert wird. Konkret ist es bevorzugt, wenn die Kühlmittelkanäle durch den Motor/Generator Statorkanäle umfassen, die durch einen Stator des Motor/Generators verlaufen. Das durch diese Statorkanäle fließende Kühlmittel kühlt nicht nur den Stator selbst, sondern auch die Lager für den Rotor des Motor/Generators.

Weiterhin ist es bevorzugt, wenn die Kühlmittelkanäle durch den Motor/Generator Gehäusekanäle umfassen, die durch ein Gehäuse des Motor/Generators verlaufen. Wenn sowohl der Stator als auch das Gehäuse des Motor/Generators durch Kühlmittel gekühlt wird, wird auch eine indirekte Kühlung des dazwischen rotierenden Rotors des Motor/Generators erreicht. Dies gilt insbesondere dann, wenn das Gehäuse des Motor/Generators nicht nur den Rotor, sondern auch die daran mechanisch angekoppelte Schwungmasse umschließt.

Bei der erfindungsgemäßen USV-Anlage ist ein besonders kompakter Aufbau des Motor/Generators bevorzugt, bei dem die Schwungmasse den Rotor des Motor/Generators umschließt. Anders gesagt ist bei der erfindungsgemäßen USV-Anlage die Masse des Rotors des Motor/Generators so weit erhöht, dass sie als mechanisch an den Rotor angekoppelte Schwungmasse wirksam ist, in deren Drehbewegung eine erhebliche kinetische Energie für die Notversorgung einer Last mit der USV-Anlage speicherbar ist. Die Schwungmasse, die an den Rotor des Motor/Generators angekoppelt ist, ist bei dieser Ausführungsform der erfindungsgemäßen USV-Anlage nicht ohne weiteres von dem Rotor abkoppelbar oder anderweitig trennbar, sondern bildet mit diesem eine geschlossene Baueinheit.

In dem Motor/Generator der erfindungsgemäßen USV-Anlage können die Statorkanäle mit den Gehäusekanälen parallel geschaltet sein. Vielfach ist es jedoch für eine Zwangsdurchströmung der Kühlmittelkanäle vorteilhaft, wenn die Statorkanäle mit den Gehäusekanälen in Reihe geschaltet sind. Dabei können die Statorkanäle stromab der Gehäusekanäle angeordnet sein.

Auch die Kühlkörper für die Leistungsendstufen können grundsätzlich mit den Kühlmittelkanälen in Reihe geschaltet sein, wobei die Kühlkörper stromab der Kühlmittelkanäle angeordnet sein können. Es kann jedoch bevorzugt sein, die Kühlkörper mit den Kühlmittelkanälen parallel zu schalten, um mit Hilfe von Ventilen in dem Kühlmittelkreislauf die Kühlmittelkühlung des Motor/Generators und der Leistungsendstufen nach den aktuellen Bedarfen unterschiedlich einstellen zu können.

Bei der erfindungsgemäßen USV-Anlage kann auch eine Kühlmittelkühlung für Filterinduktivitäten, die regelmäßig Teil des ausgangsseitigen DC/AC-Wandlers aber auch des eingangsseitigen AC/DC-Wandlers und damit ebenfalls in dem Maschinenschrank angeordnet sind, in den Kühlkreislauf integriert sein. Dabei kann es vorteilhaft sein, die Kühlmittelkühlung stromab der Kühlkörper für die Leistungsendstufen anzuordnen, weil die Filterinduktivitäten eine gewisse Temperaturerhöhung problemlos verkraften.

In dem Kühlmittelkreislauf wird vorzugsweise weiterhin ein Ausgleichsbehälter für das Kühlmittel angeordnet. Dieser kann optional ein komprimierbares Gasvolumen umfassen. Das Kühlmittel kann grundsätzlich gas- oder dampfförmig sein. Vorzugsweise handelt es sich aber um eine Kühlflüssigkeit.

Hinsichtlich der Kühlung mit Luft sind das Gebläse, die Luftfilter und weitere Luftführungseinrichtungen der erfindungsgemäßen USV-Anlage vorzugweise so angeordnet, dass sie mehrere Teilströme der Luft parallel zueinander durch den Maschinenschrank führen, die erst bei Eintritt der Luft in das Gebläse zusammengeführt werden. Einer dieser Teilströme der Luft durch den Maschinenschrank kann um den Motor/Generator herum führen und diesen zusätzlich zu der Kühlung mit dem Kühlmittel kühlen. Ein weiterer Teilstrom kann um die Filterinduktivitäten des DC/AC-Wandlers und/oder des AC/DC-Wandlers herum führen, um diese allein oder in Verbindung mit einer zusätzlichen Kühlmittelkühlung zu kühlen. Noch ein weiterer Teilstrom der Luft kann um den Bypassschalter des Bypasses herum führen, um diesen zu kühlen. Die Steuerung der USV-Anlage kann von noch einem weiteren Teilstrom der Luft gekühlt werden. Häufig reicht hier aber auch eine Konvektionskühlung aus, so dass auf eine Zwangsumwälzung der Luft im Bereich der Steuerung verzichtet werden kann.

Der Wärmetauscher in dem Kühlmittelkreislauf kann insbesondere stromab des Gebläses und damit in den zusammengeführten Teilströmen der Luft durch den Maschinenschrank angeordnet sein. In dem Wärmetauscher kann ein unmittelbarer Wärmeaustausch zwischen der Luft und dem Kühlmittel erfolgen. Die erfindungsgemäße USV-Anlage verzichtet also in der Regel auf die Verwendung eines zweiten Kühlmittels, das beispielsweise in einem Kreisprozess verdampft und wieder kondensiert werden könnte, um die Temperatur des in den Kühlmittelkreislauf geführten Kühlmittels unter die Temperatur der Luft abzusenken, die durch den Wärmetauscher geblasen wird.

Vorzugsweise umfasst der Maschinenschrank der erfindungsgemäßen USV-Anlage zwei nebeneinander angeordnete Teilschränke, die separate Transporteinheiten für die USV-Anlage ausbilden. Dabei kann eine Zwischenwand des Maschinenschranks durch zwei einander überlappende Wände der Teilschränke ausgebildet werden, die die Teilschränke gegeneinander abgrenzen, aber mit fluchtenden Luftdurchtrittsöffnungen versehen sind. Für den Transport der Teilschränke können diese Luftdurchtrittsöffnungen verschlossen sein.

Konkret kann der eine Teilschrank den Motor/Generator, das Gebläse, den Wärmetauscher und die Kühlmittelpumpe umschließen, d. h. alle Bestandteile der USV-Anlage mit beweglichen Teilen, während der andere Teilschrank die Endstufen, die Filterinduktivitäten des DC/AC-Wandlers und/oder des AC/DC-Wandlers, den Bypassschalter und die Steuerung umschließt, d. h. alle rein elektrischen bzw. elektronischen Bestandteile der USV-Anlage.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Wärmetauscher die Rede ist, ist dies so zu verstehen, dass genau ein Wärmetauscher, zwei Wärmetauscher oder mehr Wärmetauscher vorhanden sind. Die in den Patentansprüchen angeführten Merkmale können durch andere Merkmale ergänzt werden oder die einzigen Merkmale sein, die das jeweilige Erzeugnis aufweist.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: ist eine schematische Darstellung des Kühlsystems einer erfindungsgemäßen USV-Anlage.
- **Fig. 2**: ist eine schematische Darstellung des elektrischen und elektronischen Aufbaus der erfindungsgemäßen USV-Anlage gemäß Fig. 1.
- **Fig. 3**: zeigt einen Motor/Generator der erfindungsgemäßen USV-Anlage gemäß Fig. 1 in einer Ansicht von oben und
- **Fig. 4**: zeigt den Motor/Generator gemäß Fig. 3 in einer Schnittansicht gemäß einer in Fig. 3 eingezeichneten Schnittlinie A-A.

### FIGURENBESCHREIBUNG

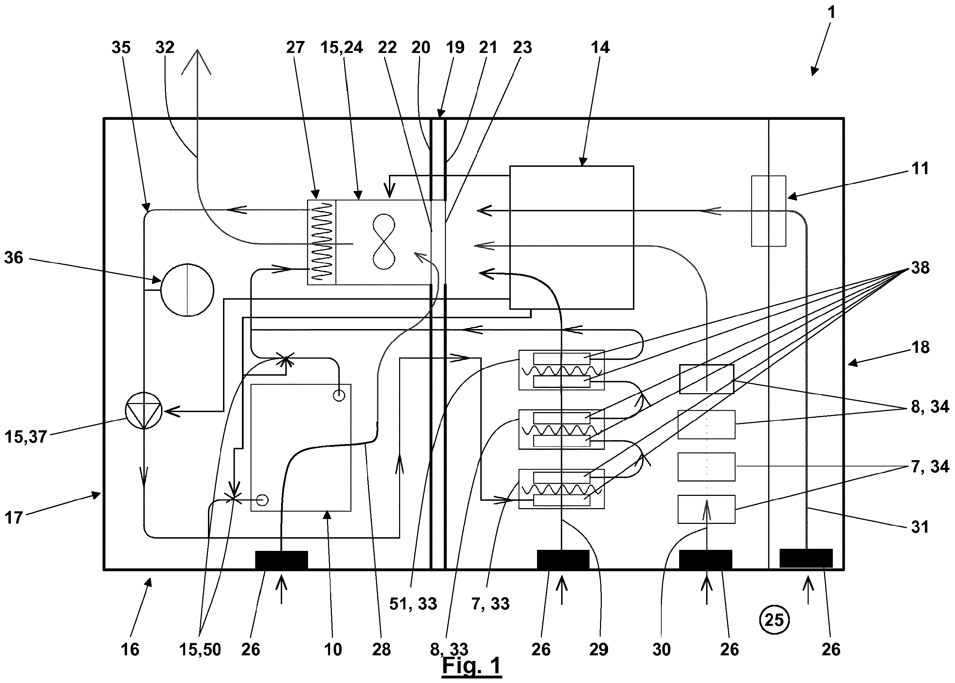

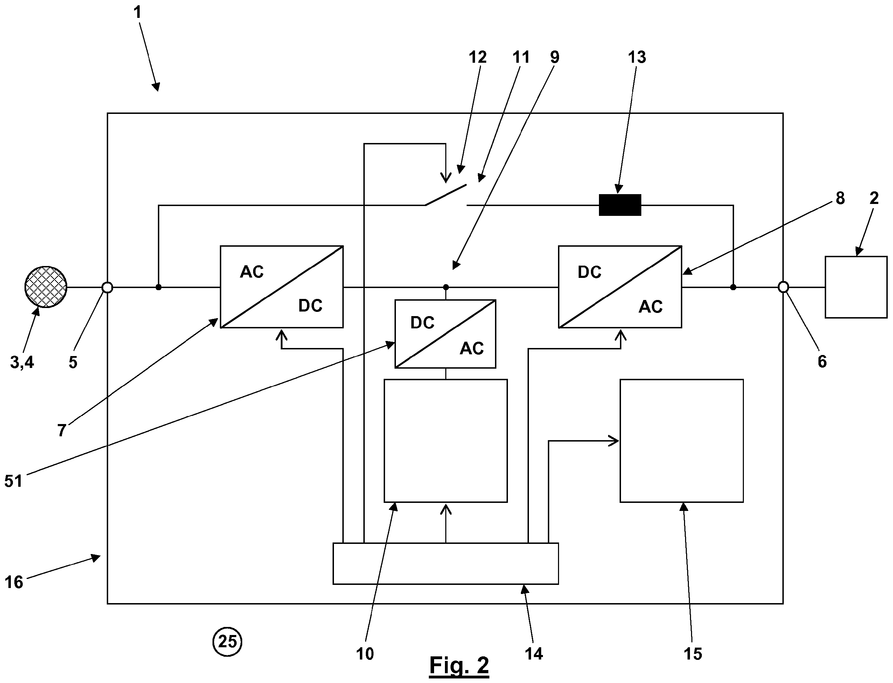

Die in den **Fig. 1** **und** **2** in Bezug auf unterschiedliche Aspekte dargestellte USV-Anlage 1 dient zur unterbrechungsfreien Versorgung einer Last 2 mit elektrischer Leistung. Dabei ist die USV-Anlage 1 zwischen die Last 2 und eine Hauptwechselstromquelle 3, beispielsweise ein öffentliches Wechselstromnetz 4, geschaltet, siehe Fig. 2. Zwischen einem Eingang 5 und einem Ausgang 6 weist die USV-Anlage 1 eine Reihenschaltung eines AC/DC-Wandlers 7 und eines DC/AC-Wandlers 8 auf, wobei an einen dazwischen liegenden Gleichspannungszwischenkreis 9 zusätzlich ein Motor/Generator 10 über einen bidirektionalen DC/AC-Wandler 51 angeschlossen ist. An den Rotor des Motor/Generators 10 ist eine Schwungmasse mechanisch angekoppelt, die im Betrieb des Motor/Generators 10 in Rotation versetzt wird. Die in der rotierenden Schwungmasse gespeicherte elektrische Energie kann über den als Generator betriebenen Motor/Generator 10 und den DC/AC-Wandler 8 zur Versorgung der Last 2 mit elektrischer Leistung genutzt werden, wenn die Hauptwechselstromquelle 3 ausfällt. Mit der Reihenschaltung des AC/DC-Wandlers 7 und des DC/AC-Wandlers 8 und unter Verwendung des Motor/Generators 10 kann die Qualität des Stroms aus der Hauptwechselstromquelle 3 verbessert und die Versorgung der Last 2 mit elektrischer Leistung stabilisiert werden, auch wenn die Hauptwechselstromquelle 3 nicht ausfällt. Weiterhin umfasst die USV-Anlage 1 einen Bypass 11 mit einem Bypassschalter 12, der parallel zu der Reihenschaltung des AC/DC-Wandlers 7 mit dem DC/AC-Wandler 8 vorgesehen ist und zur Überbrückung dieser Reihenschaltung dient, wenn die Last 2 direkt aus der Hauptwechselstromquelle 3 versorgt werden kann. Eine Grundversorgung der Last 2 aus der Hauptwechselstromquelle 3 unter Stabilisierung der an dem Ausgang 6 anliegenden Spannung mit Hilfe des DC/AC-Wandlers 8 wird durch eine zusätzliche Induktivität 13 in dem Bypass 11 ermöglicht. Für den AC/DC-Wandler 7, den DC/AC-Wandler 8, den Bypassschalter 12 und den Motor/Generator 10 ist eine Steuerung 14 der USV-Anlage 1 vorgesehen. Die Steuerung 14 steuert auch ein Kühlsystem 15 der USV-Anlage 1. Alle Bestandteile 7-15 der USV-Anlage 1 sind in einem Maschinenschrank 16 angeordnet.

Fig. 1 zeigt, dass dieser Maschinenschrank 16 zwei nebeneinander angeordnete Teilschränke 17 und 18 umfasst, wobei eine Zwischenwand 19 des Maschinenschranks 16 durch zwei überlappende Wände 20 und 21 der Teilschränke 17 und 18 ausgebildet ist, in denen fluchtende Luftdurchtrittsöffnungen 22 und 23 vorgesehen sind. In dem Teilschrank 17 sind alle Bestandteile der USV-Anlage 1 mit beweglichen Teilen angeordnet, während der Teilschrank 18 die rein elektrischen und elektronischen Bestandteile aufnimmt. Ein Gebläse 24 des Kühlsystems 15 in dem Teilschrank 17 saugt Luft aus einer Umgebung 25 durch Luftfilter 26 im Bereich des Bodens beider Teilschränke 17 und 18 in den Maschinenschrank 16 ein. Das Gebläse 24 bläst die Luft durch einen Wärmetauscher 27 und stößt sie dann wieder aus dem Maschinenschrank 16 aus.

Dabei sind die Luftfilter 26, das Gebläse 24 und weitere, auch nicht dargestellte Luftführungseinrichtungen derart ausgebildet und angeordnet, dass mehrere Teilströme 28-31 der Luft durch den Maschinenschrank 16 verlaufen, bis sich alle Teilströme 28-31 beim Eintritt der Luft in das Gebläse 24 vereinigen, und ein vereinigter Hauptstrom 32 durch den Wärmetauscher 27 und aus dem Maschinenschrank 16 herausführt. Der eine Teilstrom 28 verläuft über den Motor/Generator 10. Der Teilstrom 29 verläuft über Leistungsendstufen 33 des AC/DC-Wandlers 7, des DC/AC-Wandlers 8 und des bidirektionalen DC/AC-Wandlers 51. Der Teilstrom 30 verläuft über Filterinduktivitäten 34 des AC/DC-Wandlers 7 und des DC/AC-Wandlers 8; und der Teilstrom 31 verläuft über den Bypass 11. Die Steuerung 14 kann von diesen oder einem weiteren der Teilströme der Luft durch den Maschinenschrank 16 überströmt werden oder außerhalb dieser Teilströme angeordnet sein und rein durch Konvektion gekühlt werden. Für den Motor/Generator 10 und die Leistungsendstufen 33 des DC/AC-Wandlers 8 ist ein zusätzlicher Kühlmittelkreislauf 35 vorgesehen, in dem der Wärmetauscher 27, ein Ausgleichsbehälter 36, eine Kühlmittelpumpe 37, Kühlmittelkanäle durch den Motor/Generator 10 und Kühlkörper 38 für die Leistungsendstufen 33 angeordnet sind. Dabei sind die Kühlkanäle durch den Motor/Generator 10 und die Kühlkörper 38 hier parallel geschaltet. Mit dem Kühlmittelkreislauf 35 werden die Bestandteile der USV-Anlage 1 selektiv zusätzlich mit Kühlmittel gekühlt, die bei einer hohen Leistungsdichte der USV-Anlage 1 am ehesten dazu neigen, zu überhitzen. Zur Steuerung des Kühlsystems 15 kann die Steuerung 14 neben dem Gebläse 24 auf die Kühlmittelpumpe 37 und auf Ventile 50, die die relative Durchströmung der Kühlmittelkanäle durch den Motor/Generator 10 gegenüber der Durchströmung der Kühlkörper 38 festlegen, einwirken. Die Ventile müssen aber nicht von der Steuerung 14 angesteuert werden, sondern können auch nur einmalig eingestellt werden, um die relativen Durchströmung der Kühlmittelkanäle durch den Motor/Generator 10 und der Kühlkörper 38 festzulegen.

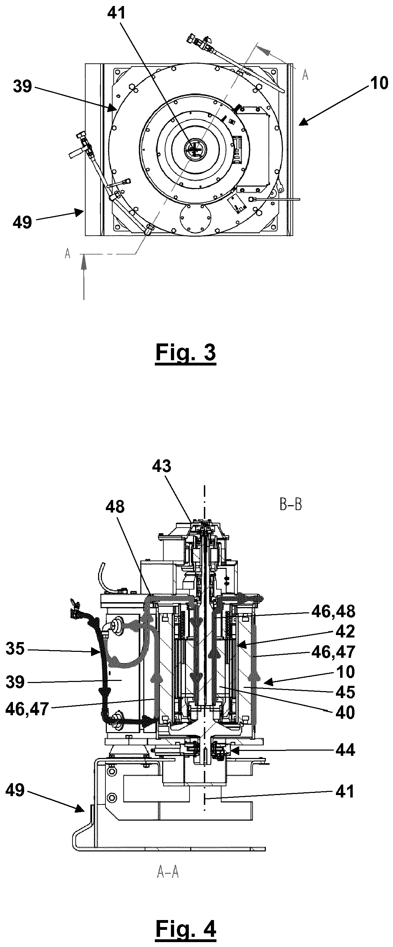

Die **Fig. 3** zeigt den Motor/Generator 10 der USV-Anlage 1 in einer Ansicht von oben und **Fig. 4** in einer Schnittansicht mit vertikalem Schnitt längs der Schnittlinie A-A gemäß Fig. 3. Der Motor/Generator 10 weist ein Gehäuse 39 auf, in dessen Mitte ein Stator 40 angeordnet ist. Um den Stator 40 herum ist um eine vertikale Drehachse 41 drehbar ein Rotor 42 in Drehlagern 43 und 44 gelagert. Der Rotor 42 ist mechanisch mit einer Schwungmasse 45 gekoppelt, die mit dem Rotor 42 die Drehachse 41 umläuft. Bei Betrieb des Motor/Generators 10 als Motor wird die Schwungmasse 45 in Rotation um die Drehachse 41 versetzt, um in der Schwungmasse 45 kinetische Energie zu speichern. Diese kinetische Energie kann wieder in elektrische Energie umgewandelt werden, wenn der Motor/Generator 10 als Generator betrieben wird. Die Kühlmittelkanäle 46 des Kühlkreislaufs 35 durch den Motor/Generator 10 umfassen Gehäusekanäle 47 durch das Gehäuse 39 und zur Kühlung des Gehäuses 39 sowie Statorkanäle 48 durch den Stator 40. Weiter zeigt Fig. 4 ein unteres Auflager 49, über das der Motor/Generator 10 in dem Teilschrank 17 des Maschinenschranks 16 gelagert ist.

### BEZUGSZEICHENLISTE

- 1: USV-Anlage
- 2: Last
- 3: Hauptwechselstromquelle
- 4: öffentliches Stromnetz
- 5: Eingang
- 6: Ausgang
- 7: AC/DC-Wandler
- 8: DC/AC-Wandler
- 9: Gleichspannungszwischenkreis
- 10: Motor/Generator
- 11: Bypass
- 12: Bypassschalter
- 13: Induktivität
- 14: Steuerung
- 15: Kühlsystem
- 16: Maschinenschrank
- 17: Teilschrank
- 18: Teilschrank
- 19: Zwischenwand
- 20: Wand
- 21: Wand
- 22: Luftdurchtrittsöffnung
- 23: Luftdurchtrittsöffnung
- 24: Gebläse
- 25: Umgebung
- 26: Luftfilter
- 27: Wärmetauscher
- 28: Teilstrom
- 29: Teilstrom
- 30: Teilstrom
- 31: Teilstrom
- 32: Hauptstrom
- 33: Leistungsendstufe
- 34: Filterinduktivität
- 35: Kühlmittelkreislauf
- 36: Ausgleichsbehälter
- 37: Kühlmittelpumpe
- 38: Kühlkörper
- 39: Gehäuse
- 40: Stator
- 41: Drehachse
- 42: Rotor
- 43: Drehlager
- 44: Drehlager
- 45: Schwungmasse
- 46: Kühlmittelkanal
- 47: Gehäusekanal
- 48: Statorkanal
- 49: Auflager
- 50: Ventil
- 51: bidirektionaler DC/AC-Wandler

## Patentansprüche

1. USV-Anlage (1), bei der folgende Bestandteile in einem Maschinenschrank (16) angeordnet sind:
- ein ausgangsseitig an einen Gleichspannungszwischenkreis (9) angeschlossener AC/DCWandler (7) mit einer Leistungsendstufe (33),
- ein eingangsseitig an den Gleichspannungszwischenkreis (9) angeschlossener DC/ACWandler (8) mit einer weiteren Leistungsendstufe (33),
- ein an den Gleichspannungszwischenkreis (9) angeschlossener bidirektionaler DC/AC-Wandler (51) mit noch einer weiteren Leistungsendstufe (33),
- ein AC-seitig an den bidirektionalen DC/AC-Wandler (51) angeschlossener Motor/Generator (10), an dessen Rotor (42) eine Schwungmasse (45) mechanisch angekoppelt ist,
- ein Bypass (11) zu der Reihenschaltung des AC/DC-Wandlers (7) mit dem DC/AC-Wandler (8), in dem ein Bypassschalter (12) angeordnet ist,
- eine Steuerung (14) für den AC/DC-Wandler (7), den DC/AC-Wandler (8), den Motor/Generator (10) und den Bypassschalter (12) sowie
- ein Luft aus einer Umgebung (25) des Maschinenschranks (16) durch Luftfilter (26) in den Maschinenschrank (16) einsaugendes, die Luft in dem Maschinenschrank (16) durch einen Wärmetauscher (27) blasendes und die Luft wieder aus dem Maschinenschrank (16) ausstoßendes Gebläse (24),
**dadurch gekennzeichnet, dass** der Wärmetauscher (27) zusammen mit einer Kühlmittelpumpe (37), Kühlmittelkanälen (46) durch den Motor/Generator (10) und Kühlkörpern (38) für die Leistungsendstufen (33) in einem Kühlmittelkreislauf (35) angeordnet ist.

2. USV-Anlage (1) nach Anspruch 1, **dadurch gekennzeichnet, dass** die Kühlmittelkanäle (46) Statorkanäle (48) umfassen, die durch einen Stator (40) des Motor/Generators (10) verlaufen.

3. USV-Anlage (1) nach einem der vorhergehenden Ansprüche, **dadurch gekennzeichnet, dass** die Kühlmittelkanäle (46) Gehäusekanäle (47) umfassen, die durch ein Gehäuse (39) des Motor/Generators (10) verlaufen.

4. USV-Anlage (1) nach Anspruch 3, soweit rückbezogen auf Anspruch 2, **dadurch gekennzeichnet, dass** die Statorkanäle (48) mit den Gehäusekanälen (47) parallel geschaltet sind oder dass die Statorkanäle (48) mit den Gehäusekanälen (47) in Reihe geschaltet sind, wobei die Statorkanäle (48) optional stromab der Gehäusekanäle (47) angeordnet sind.

5. USV-Anlage (1) nach Anspruch 3 oder Anspruch 4, soweit rückbezogen auf Anspruch 3, **dadurch gekennzeichnet, dass** das Gehäuse (39) den Rotor (42) und die daran angekoppelte Schwungmasse (45) umschließt.

6. USV-Anlage (1) nach einem der vorhergehenden Ansprüche, **dadurch gekennzeichnet, dass** die Schwungmasse (45) den Rotor (42) des Motor/Generators (10) umschließt.

7. USV-Anlage (1) nach einem der vorhergehenden Ansprüche, **dadurch gekennzeichnet, dass** die Kühlkörper (38) mit den Kühlmittelkanälen (46) parallel geschaltet sind oder dass die Kühlkörper (38) mit den Kühlmittelkanälen (46) in Reihe geschaltet sind, wobei die Kühlkörper (38) optional stromab der Kühlmittelkanäle (46) angeordnet sind.

8. USV-Anlage (1) nach einem der vorhergehenden Ansprüche, **dadurch gekennzeichnet, dass** in dem Kühlmittelkreislauf (35) eine Kühlmittelkühlung für Filterinduktivitäten (34) des AC/DC-Wandlers (7) und/oder des DC/AC-Wandlers (8) angeordnet ist, wobei die Kühlmittelkühlung optional stromab der Kühlkörper (38) angeordnet ist.

9. USV-Anlage (1) nach einem der vorhergehenden Ansprüche, **dadurch gekennzeichnet, dass** in dem Kühlmittelkreislauf (35) ein Ausgleichsbehälter (36) angeordnet ist, der optional in komprimierbares Gasvolumen umfasst.

10. USV-Anlage (1) nach einem der vorhergehenden Ansprüche, **dadurch gekennzeichnet, dass** das Gebläse (24), die Luftfilter (26) und weitere Luftführungseinrichtungen so angeordnet und ausgebildet sind, dass sie einen ersten Teilstrom (28) der Luft durch den Maschinenschrank (16) um den Motor/Generator (10) herum führen.

11. USV-Anlage (1) nach einem der vorhergehenden Ansprüche, **dadurch gekennzeichnet, dass** das Gebläse (24), die Luftfilter (26) und weitere Luftführungseinrichtungen so angeordnet und ausgebildet sind, dass sie einen zweiten Teilstrom (30) der Luft durch den Maschinenschrank (16) um Filterinduktivitäten (34) des AC/DC-Wandlers (7) und/oder des DC/AC-Wandlers (8) herum führen.

12. USV-Anlage (1) nach einem der vorhergehenden Ansprüche, **dadurch gekennzeichnet, dass** das Gebläse (24), die Luftfilter (26) und weitere Luftführungseinrichtungen so angeordnet und ausgebildet sind, dass sie einen dritten Teilstrom (31) der Luft durch den Maschinenschrank (16) um den Bypassschalter (12) herum führen.

13. USV-Anlage (1) nach einem der Ansprüche 10 bis 12, **dadurch gekennzeichnet, dass** das Gebläse (24) und die weiteren Luftführungseinrichtungen so angeordnet und ausgebildet sind, dass sie alle Teilströme (28, 29, 30, 31) beim Eintritt der Luft in das Gebläse (24) zusammenführen, wobei der Wärmetauscher (27) optional stromab des Gebläses (24) angeordnet ist.

14. USV-Anlage (1) nach einem der vorhergehenden Ansprüche, **dadurch gekennzeichnet, dass** der Maschinenschrank (16) zwei nebeneinander angeordnete Teilschränke (17, 18) aufweist, wobei eine Zwischenwand (19) des Maschinenschranks (16) durch zwei einander überlappende Wände (20, 21) der Teilschränke (17, 18) mit fluchtenden Luftdurchtrittsöffnungen (22, 23) ausgebildet ist.

15. USV-Anlage (1) nach Anspruch 14, **dadurch gekennzeichnet, dass** der eine Teilschrank (17) den Motor/Generator (10), das Gebläse (24), den Wärmetauscher (27) und die Kühlmittelpumpe (37) umschließt und dass der andere Teilschrank (18) die Endstufen (33), Filterinduktivitäten (34) des AC/DC-Wandlers (7) und/oder des DC/AC-Wandlers (8), den Bypassschalter (12) und die Steuerung (14) umschließt.
